# EUROPÄISCHE PATENTSCHRIFT

(11) **EP 2 255 605 B1**
(45) Veröffentlichungstag und Bekanntmachung des Hinweises auf die Patenterteilung: **03.10.2012**
(21) Anmeldenummer: 09720728.6
(22) Anmeldetag: 04.03.2009
(51) Int. Cl.: H05K 7/20

(54) **KLIMATISIERUNGSEINRICHTUNG FÜR ELEKTRONISCHE BAUELEMENTE**
AIR-CONDITIONING SYSTEM FOR ELECTRONIC COMPONENTS
DISPOSITIF DE CLIMATISATION POUR COMPOSANTS ÉLECTRONIQUES

(30) Priorität: 12.03.2008 DE 102008013850
(43) Veröffentlichungstag der Anmeldung: 01.12.2010
(73) Patentinhaber: NFT Nanofiltertechnik Gesellschaft mit beschränkter Haftung, 61348 Bad Homburg v.d.H. (DE)
(72) Erfinder: HOFMANN, Wilfried, 80801 München (DE); JOCHAM, Simon, 80469 München (DE); NICOLAI, Walter, 35418 Buseck (DE)
(74) Vertreter: von Bülow, Tam
(86) Internationale Anmeldenummer: PCT/EP2009/001510
(87) Internationale Veröffentlichungsnummer: WO 2009/112185

(56) Entgegenhaltungen:
- DE-A1- 10 218 115
- DE-A1-102004 030 675
- DE-A1-102006 034 487
- DE-U1- 20 007 920
- DE-U1- 20 104 334

## Beschreibung

Die Erfindung bezieht sich auf eine Klimatisierungseinrichtung für elektronische Bauelemente gemäß dem Oberbegriff des Patentanspruches 1.

Eine solche Klimatisierungseinrichtung ist aus der DE 102 18 115 A1 bekannt. Diese Klimatisierungseinrichtung für elektronische Bauelemente hat eine Trennwand, die beidseitig mit Wärmetauscherelementen versehen ist und einen ersten Kanal mit einem Einlaß und einem Auslaß für ein strömendes erstes Fluid abgrenzt, wobei in einer ersten Betriebsart der Einrichtung an der dem ersten Kanal abgewandten Seite der Trennwand ein zweites Fluid in Wärmetausch mit dem ersten Fluid und den elektrischen Bauelementen steht.

Eine ähnliche ist aus der DE 10 2004 030 675 A1 bekannt. Dort ist eine Kühleinrichtung für elektronische Bauelemente beschrieben, die eine Montageplatte aufweist, an der elektronische Bauelemente in wärmeleitendem Kontakt befestigt sind. An der Montageplatte sind mehrere Wärmetauscherelemente befestigt. Die Montageplatte bildet dabei die Rückwand eines Schaltschrankes und ist durch eine Abdeckung abgedeckt, so daß sich ein außerhalb des Innenraumes des Schaltschrankes liegender Strömungskanal bildet, dem Außenluft über einen Lüfter zugeführt wird. Im Innenraum kann eine zusätzliche Strömung längs der Montageplatte durch Konvektion oder einen weiteren Lüfter erzeugt werden.

Weiter ist dort vorgeschlagen, spezielle Wärmetauscherelemente zu verwenden, wie sie in der DE 102 33 736 beschrieben sind.

Diese bekannten Kühleinrichtungen arbeiten im Prinzip mit einem Luft/Luft-Wärmetausch, wobei davon ausgegangen wird, daß die Außenluft kälter ist als die Innenluft im Innenraum des Schaltschrankes. Bekanntlich hängt der Wärmeübergang an einem Wärmetauscher ganz wesentlich von der Temperaturdifferenz der miteinander im Wärmetausch stehenden Medien ab. Damit ist die Kühlleistung der bekannten Einrichtungen bei hohen Außentemperaturen nicht zufriedenstellend.

Im Stand der Technik sind daher auch schon aktive Kühleinrichtungen bekannt, die nach dem Prinzip eines Kühlschranks mit Kompressor arbeiten (vgl. US 5706668) oder mit Peltierelementen. So beschreibt beispielsweise die DE 10 2006 034 487 A1 einen Wärmetauscher mit Peltierelementen, die beidseitig mit Wärmeabgabe- und Wärmeaufnahmeelementen in wärmeübertragenden Kontakt stehen, wobei an die Wärmeabgabe- und die Wärmeaufnahmeelemente jeweils ein Fluid-Erwärmungs- und ein Fluid-Abkühlkanal angrenzen.

Kühleinrichtungen mit Peltierelementen sind auch in der DE 10 2006 020 502, DE 10 2006 020 503, DE 20104334U1, DE 10 2006 020 499, DE 299 21 448 U1, DE 203 01 232 U1 beschrieben.

Die DE 201 05 487 U1 beschreibt ein Kühlgerät mit Peltierelementen, bei dem eine Umschaltung zwischen einzelnen Kühlmodi in Abhängigkeit von der Umgebungstemperatur dadurch möglich ist, daß die Peltierelemente entweder alle parallel geschaltet sein können, oder gruppenweise oder insgesamt in Reihe, womit die Kühlleistung in einfacher Weise steuerbar ist.

Die DE 200 07 920 U1 beschreibt eine Belüftungsvorrichtung für ein Gehäuse mit Peltierelementen, bei dem der Luftstrom wahlweise umgekehrt werden kann, um zwischen Kühl- und Heizbetrieb umzuschalten.

Peltierelemente sind heute als flache Plättchen mit Wärmeabgabe- und Wärmeaufnahmeseite erhältlich. Nachteilig ist naturgemäß ihr Verbrauch an elektrischer Energie und das Problem, daß der Wirkungsgrad bzw. die Kühlleistung temperaturabhängig sind und mit steigender Temperaturdifferenz zwischen Wärmeabgabeseite und Wärmeaufnahmeseite abnimmt.

Aufgabe der Erfindung ist es, das Klimatisierungsgerät der eingangs genannten Art dahingehend zu verbessern, daß es in einem großen Temperaturbereich der Außentemperatur mit möglichst geringem Verbrauch an elektrischer Energie die Temperatur elektronischer Bauelemente möglichst gut innerhalb eines vorgegebenen Temperaturbereiches hält.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Das Grundprinzip der Erfindung besteht darin, zwischen Luft/Luft-Wärmetausch und Peltier-Betrieb umzuschalten. Hierzu sind drei Strömungskanäle vorgesehen, die durch umschaltbare Klappen ausgewählt werden können, so daß jeweils nur zwei Kanäle von einem Wärmetauschmedium, insbesondere Luft, durchströmt sind.

In einem konkreten Ausführungsbeispiel sind ein Innenkanal, ein Mittelkanal und ein Außenkanal vorgesehen. Der Innenkanal grenzt an einen Innenraum an, in dem die elektronischen Bauelemente angeordnet sind. Zwischen dem Innenkanal und dem Mittelkanal ist ein Peltierelement angeordnet, das beidseitig mit Wärmetauscherelementen versehen ist.

Zwischen dem Mittelkanal und dem Außenkanal ist eine Trennwand angeordnet, die ebenfalls beidseitig mit Wärmetauscherelementen beschichtet ist.

In der Betriebsart "Luft/Luft-Wärmetausch" sind Strömungswege durch die Klappen so ausgewählt, daß Außenluft durch den Außenkanal und Innenluft durch den Mittelkanal strömt, so daß ein Wärmetausch über die Wärmetauschelemente an der Trennwand zwischen Mittelkanal und Außenkanal stattfindet.

Beim Peltierbetrieb sind die Strömungswege so durch die Klappen ausgewählt, daß die Außenluft durch den Mittelkanal strömt und die Innenluft durch den Innenkanal. Die beiden Luftströme fließen somit an beiden Seiten des Peltierelementes. Hierdurch kann sowohl ein aktiver Kühlbetrieb als auch ein aktiver Heizbetrieb vorgenommen werden, je nach Polarität der an das Peltierelement angelegten elektrischen Spannung.

In diesem Zusammenhang sei darauf hingewiesen, daß der Begriff Peltierelement im Singular eine Einheit umfaßt, die mehrere Peltierelemente enthält, die wirkungsmäßig zu einer Platte zusammengefaßt sind, wobei diese Platte beidseitig mit den erwähnten Wärmetauscherelementen versehen ist und somit eine Trennwand zwischen dem Innenkanal und dem Mittelkanal bildet.

Bei ausreichender Temperaturdifferenz zwischen Außenluft und Innenluft wird die Betriebsart Luft/Luft-Wärmetausch gewählt, bei der das Peltierelement deaktiviert, also stromlos ist und somit keine elektrische Energie verbraucht. Es wird lediglich elektrische Energie für den Betrieb eines oder mehrerer Lüfter benötigt.

Bei hoher Außentemperatur, bei der der Luft/Luft-Wärmetausch nicht mehr ausreichend ist, um die elektronischen Bauelemente auf ihrem BetriebsTemperaturbereich zu halten, wird auf Peltierbetrieb umgeschaltet und damit eine aktive Kühlung eingeleitet.

In manchen Anwendungsfällen, beispielsweise wenn ein Schaltschrank in einem Außenbereich aufgestellt ist, kann auch ein Heizbetrieb erforderlich sein. Hier wird dann ebenfalls auf Peltierbetrieb umgeschaltet und das Peltierelement als Heizelement eingesetzt.

Die Klimatisierungseinrichtung nach der Erfindung kann als sehr flache Baueinheit realisiert sein, die sowohl an einer Außenwand oder einer Tür eines Schaltschrankes angebracht werden kann, als auch als Einschub in einen Schaltschrank, so daß das Klimatisierungsgerät gezielt an bestimmten Stellen im Schaltschrank eingesetzt werden kann, wo aufgrund der dort angeordneten Bauelemente besonders hohe Temperaturen entstehen können.

Im folgenden wird die Erfindung anhand von Ausführungsbeispielen im Zusammenhang mit der Zeichnung ausführlicher erläutert. Es zeigt:
- Figur 1: eine Prinzipskizze eines Klimatisierungsgerätes nach der Erfindung in der Betriebsart Luft/Luft-Wärmetausch;
- Figur 2: das Klimatisierungsgerät nach der Erfindung in der Betriebsart Peltier-Wärmetausch;
- Figur 3: das Klimatisierungsgerät nach der Erfindung bei Einbau in einen Schaltschrank in der Betriebsart Peltier-Betrieb und
- Figur 4: das Klimatisierungsgerät der Figur 3 in der Betriebsart Luft/Luft-Wärmetausch.

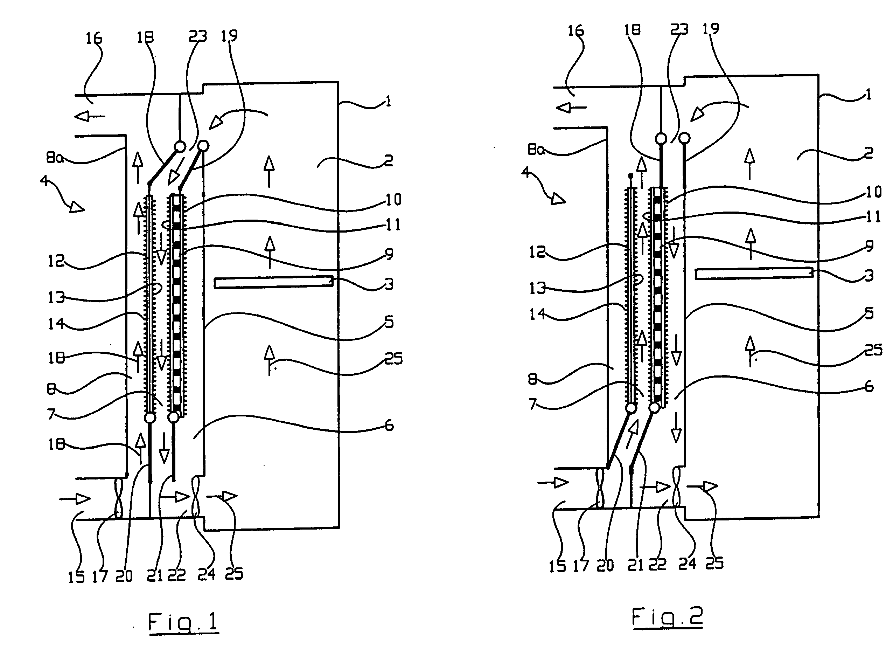

Figur 1 zeigt einen Schaltschrank 1 mit einem Innenraum 2, in dem ein oder mehrere elektronische Geräte 3 angeordnet sind.

Das Klimatisierungsgerät 4 nach der Erfindung ist an einer Außenwand des Schaltschrankes angebracht, wobei diese Außenwand 5 gleichzeitig eine Wand eines Innenkanales 6 bildet.

An den Innenkanal 6 schließen sich ein Mittelkanal 7 und ein Außenkanal 8 an. Der Innenkanal 6 und der Mittelkanal 7 sind durch ein Peltierelement 9 voneinander getrennt, das beidseitig mit Wärmetauscherelementen 10 und 11 bedeckt ist. Die Wärmetauscherelemente 10 weisen zum Innenkanal 6 hin. Die Wärmetauscherelemente 11 weisen zum Mittelkanal 7 hin.

Der Mittelkanal 7 und der Außenkanal 8 sind durch eine Trennwand 12 voneinander getrennt, wobei die Trennwand ebenfalls beidseitig mit Wärmetauscherelementen 13 und 14 bedeckt ist. Die Wärmetauscherelemente 13 weisen zum Mittelkanal hin. Die Wärmetauscherelemente 14 weisen zum Außenkanal hin. Der Außenkanal ist durch eine Außenwand 8a abgegrenzt.

Der Außenkanal 8 hat einen Lufteinlaß 15 für Außenluft und an seinem anderen Ende einen Luftauslaß 16 für die Außenluft. Ein Ventilator 17 ist hier nahe dem Lufteinlaß 15 angeordnet und sorgt dafür, daß Außenluft vom Lufteinlaß 15 durch einen ausgewählten Kanal strömt und am Luftauslaß 16 abgeleitet wird. Am Lufteinlaß kann zusätzlich ein nicht dargestellter Schalldämpfer und/oder ein ebenfalls nicht dargestellter Schmutz- und/oder Feuchtigkeitsfilter angeordnet sein.

An beiden Enden der drei genannten Kanäle 6, 7, 8 sind umschaltbare Klappen 18, 19, 20, 21 angebracht. Die erste Klappe 18 ist zwischen der Trennwand 12 und dem Peltierelement 9 umschaltbar. Die zweite Klappe 19 ist zwischen dem Peltierelement und der Wand 5 umschaltbar. Die dritte Klappe 20 ist zwischen der Trennwand 12 und der Außenwand 8a des Klimatisierungsgerätes 4 umschaltbar. Die vierte Klappe 21 ist zwischen dem Peltierelement und einem Gehäuseteil umschaltbar.

Das Klimatisierungsgerät 4 ist weiterhin mit einem Lufteinlaß 22 mit dem Innenraum 2 verbunden, über den Luft mittels eines Ventilators 24 durch den Innenraum 2 in Richtung der Pfeile 25 gefördert wird und über einen Luftauslaß des Innenraumes 2 zurück zu dem Klimatisierungsgerät 4 geleitet wird. Die Innenluft wird somit in einem geschlossenen Kreislauf in Richtung der Pfeile 25 durch den Innenraum 2 und das Klimatisierungsgerät geleitet, so daß keine Außenluft und damit auch keine Verschmutzungen und Feuchtigkeit in den Innenraum 2 gelangen können. Der Ventilator 24 für die Umwälzung der Innenluft kann auch am Luftauslaß 23 oder an geeigneter Position neben den Kanälen angeordnet sein.

Die Außenluft wird entlang der Pfeile 18 geleitet.

In der in Figur 1 dargestellten Betriebsart sind die Klappen 18 bis 21 so gestellt, daß die Außenluft entlang des Pfeiles 18 durch den Außenkanal 8 strömt und die Innenluft durch den Mittelkanal 7, wobei Innen - und Außenluft in entgegengesetzter Richtung fließen, also im Gegenstrombetrieb. Innen- und Außenluft strömen somit an den Wärmetauscherelementen 13 und 14 entlang und stehen damit in Luft/Luft-Wärmetausch. Der Innenkanal 6 ist dabei für die Strömung der Innenluft abgesperrt und das Peltierelement 9 ist stromlos und damit inaktiv.

In der Betriebsart der Figur 2 sind die Klappen 18 bis 21 so umgeschaltet, daß die Außenluft durch den Mittelkanal 7 und die Innenluft durch den Innenkanal 6 strömt. Diese beiden Strömungen fließen ebenfalls im Gegenstrom an beiden Seiten des Peltierelementes 9 und deren Wärmetauscherelementen 10 und 11 entlang. Im Kühlbetrieb ist die zum Innenkanal 6 weisende Seite des Peltierelementes 9 die kalte Seite und die zum Mittelkanal 7 weisende Seite die heiße Seite. Die aus dem Innenraum 2 kommende erwärmte Luft wird somit im Innenkanal 6 abgekühlt. Die durch das Peltierelement 9 zur heißen Seite hin transportierte Wärme der kalten Seite wird durch die Außenluft, die durch den Mittelkanal strömt, abgeführt. Damit wird eine aktive Kühlung des Innenraumes durch das aktive Peltierelement erreicht.

Beim Heizbetrieb, der ebenfalls in der Konfiguration der Figur 2 möglich ist, wird das Peltierelement 9 als Heizelement verwendet. Die heiße Seite weist dann zum Innenkanal 6 und die kalte Seite zum Mittelkanal 7. Die aus dem Innenraum 2 durch den Innenkanal 6 fließende kalte Luft wird erwärmt und im Mittelkanal wird die "Kälte" über die Außenluft abgeführt.

Dem Fachmann ist klar, daß zur feineren Regelung je nach Temperatur der Innenluft und der Außenluft sowohl die Drehzahl eines der Ventilatoren 17 und 24 oder auch beider Ventilatoren 17 und 24 verändert werden kann und beim Peltierbetrieb zusätzlich oder alternativ auch die Kühlleistung des Peltierelementes durch Regelung der dem Peltierelement zugeführten elektrischen Energie oder auch durch entsprechende Schaltung der Einzelelemente des Peltierelementes 9 in Parallelschaltung, gruppenweise Reihenschaltung oder Reihenschaltung.

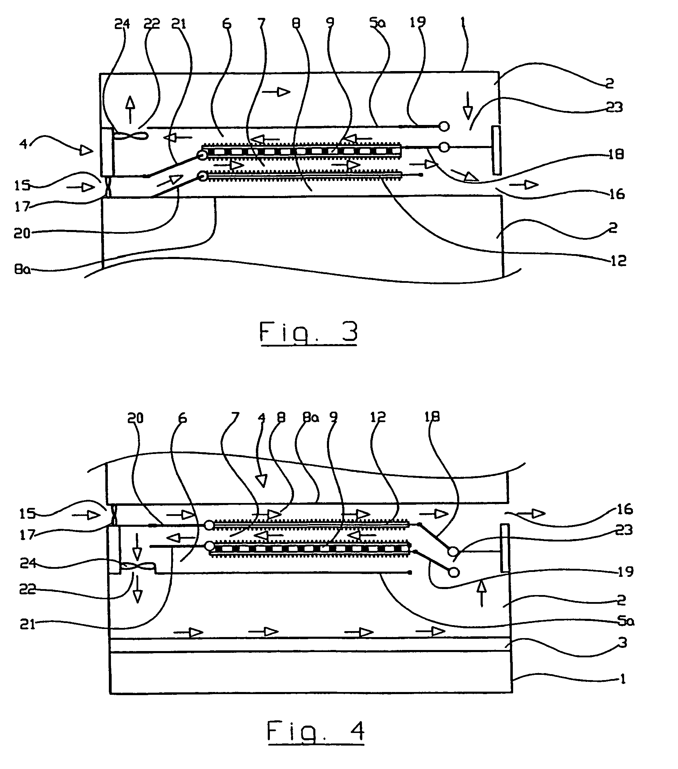

Die Figuren 3 und 4 zeigen den Einbau des Klimatisierungsgerätes 4 in den Innenraum 2 eines Schaltschrankes 1. Das Klimatisierungsgerät 4 ist damit ein Einschub, der in den Schaltschrank eingesetzt wird und nicht, wie bei Figur 1 und 2, an eine Außenwand oder Tür des Schaltschrankes angebaut.

Das Klimatisierungsgerät 4 der Figuren 3 und 4 hat hier zwei eigenständige Außenwände 5a und 8a. Die Wand 5a grenzt an den Innenkanal 6 an und die Wand 8a an den Außenkanal 8. Der Lufteinlaß 15 und der Luftauslaß 16 für die Außenluft sind als seitliche Öffnungen vorgesehen, wobei der Schaltschrank 1 entsprechende damit fluchtende Öffnungen hat. Der Lufteinlaß 22 für die Zufuhr der Innenluft in den Innenraum 2 und der entsprechende Luftauslaß 23 sind dem Innenraum 2 zugewandt und liegen in der Darstellung der Figur 3 und 4 in einer horizontalen Ebene. In Figur 3 verläßt die Innenluft das Klimatisierungsgerät in Richtung nach oben in den Innenraum 2, während in Figur 4 die Luft nach unten in den Innenraum 2 geblasen wird. Man erkennt die Flexibilität der Einbaumöglichkeiten.

In Figur 3 sind die Klappen 18 bis 21 für Peltierbetrieb gestellt und in Figur 4 für Luft/Luft-Wärmetausch-Betrieb.

Es ist offensichtlich, daß das Klimatisierungsgerät analog den Ausführungsbeispielen der Figuren 3 und 4 auch an einer Bodenwand oder einer Deckenwand des Schaltschrankes 1 angebaut werden kann, womit dann die Wand 8a des Klimatisierungsgerätes wiederum fortgelassen und durch die entsprechende Wand des Schaltschrankes 1 ersetzt werden kann. Lufteinlaß 15 und Luftauslaß 16 für die Außenluft können dann auch so angeordnet sein, daß die Luft vertikal zur Wand 8a ein- und ausströmt. Abschließend sei noch darauf hingewiesen, daß die Wärmetauscherelemente 10, 11, 13 und 14 vorzugsweise gemäß der DE 102 33 736 B3 ausgebildet sind. Diese Wärmetauscherelemente haben den wesentlichen Vorteil einer sehr geringen Bauhöhe bei hervorragender Wärmetauschfähigkeit. Abschließend sei darauf hingewiesen, daß auch die Wand 5 mit Wärmetauscherelementen versehen sein kann, was dann zweckmäßig ist, wenn diese Wand 5 selbst wärmeleitend ist, also insbesondere aus Metall besteht.

Auch sei darauf hingewiesen, daß die Wand 12 und die Peltierelemente 9 samt den zugehörigen Wärmetauscherelementen vertauscht werden können, was dann selbstverständlich eine Anpassung der Steuerung der Klappen 18 bis 21 bedingt. Die Begriffe Innenkanal, Mittelkanal und Außenkanal sind daher nicht einschränkend zu verstehen und können auch als erster, zweiter und dritter Kanal interpretiert werden, unabhängig von ihrer relativen Lage in Bezug auf den Innenraum 2.

Zusammengefaßt schafft die Erfindung ein Hybridgerät in sehr kompakter Bauweise mit hoher Leistungsdichte und geringem Energiebedarf, das mindestens zwei Betriebsarten hat, nämlich Luft/Luft-Wärmetausch (Konvektion) und aktive Kühlung (Peltier-Betrieb). Das Gerät kann in einem erweiterten Temperaturbereich betrieben werden und zwar sowohl wenn die Außentemperatur größer als die Innentemperatur ist, als auch wenn die Außentemperatur kleiner als die Innentemperatur ist. In der Betriebsart Luft/Luft-Wärmetausch bei abgeschalteten Peltierelementen werden die Komponenten der Peltierelemente geschont und die Lebensdauer der Peltierelemente erhöht.

## Patentansprüche

1. Klimatisierungseinrichtung für elektronische Bauelemente mit einer Trennwand (12), die beidseitig mit Wärmetauscherelementen (12, 13) versehen ist und einen ersten Kanal (8) mit einem Einlaß (15) und einem Auslaß (16) für ein strömendes erstes Fluid abgrenzt, wobei in einer ersten Betriebsart der Einrichtung an der dem ersten Kanal (8) abgewandten Seite der Trennwand (12) ein zweites Fluid in Wärmetausch mit dem ersten Fluid und den elektrischen Bauelementen (3) steht, **dadurch gekennzeichnet,**
**daß** die Klimatisierungseinrichtung (4) drei Kanäle (6, 7, 8) aufweist, wobei die Trennwand (12) einen Außenkanal (8) von einem Mittelkanal (7) trennt,
**daß** ein beidseitig mit Wärmetauscherelementen (10, 11) versehenes Peltierelment (9) den Mittelkanal (7) von einem Innenkanal (6) trennt, und daß umschaltbare Klappen (18, 19, 20, 21) an den Enden der Kanäle (6, 7, 8) vorgesehen sind, die das erste Fluid wahlweise in der ersten Betriebsart durch den Außenkanal (8) und in einer zweiten Betriebsart durch den Mittelkanal (7) leiten und das zweite Fluid (25) wahlweise in der ersten Betriebsart durch den Mittelkanal (7) und in der zweiten Betriebsart durch den Innenkanal (6).

2. Klimatisierungseinrichtung nach Anspruch 1, **dadurch gekennzeichnet, daß** das erste Fluid Außenluft und das zweite Innenluft aus einem Innenraum (2) eines Schaltschrankes (1) ist, in dem die elektrischen Bauelemente (3) angeordnet sind.

3. Klimatisierungseinrichtung nach Anspruch 2, **dadurch gekennzeichnet, daß** je ein Ventilator (17, 24) für die Innenluft und die Außenluft vorgesehen sind.

4. Klimatisierungseinrichtung nach einem der Ansprüche 1 bis 3, **dadurch gekennzeichnet, daß** das Peltierelement (9) in einer dritten Betriebsart als Heizelement zum Erwärmen des zweiten Fluides geschaltet ist.

5. Klimatisierungseinrichtung nach einem der Ansprüche 1 bis 4, **dadurch gekennzeichnet, daß** es an einer Außenwand (5) oder einer Tür eines Schaltschrankes (1) angebracht ist, wobei dessen Außenwand (5) den Innenkanal (6) begrenzt.

6. Klimatisierungseinrichtung nach einem der Ansprüche 1 bis 4, **dadurch gekennzeichnet, daß** es als Einschub in einen Schaltschrank (1) ausgebildet ist, der eine Einlaß- und eine Auslaßöffnung für Außenluft aufweist, die mit dem Einlaß (15) und dem Auslaß (16) für das erste Fluid ausgerichtet sind.

7. Klimatisierungseinrichtung nach einem der Ansprüche 1 bis 6, **dadurch gekennzeichnet, daß** das Peltierelement (9) in der ersten Betriebsart deaktiviert und in der zweiten Betriebsart hinsichtlich seiner elektrischen Energieaufnahme regelbar ist.

8. Klimatisierungseinrichtung nach einem der Ansprüche 3 bis 7, **dadurch gekennzeichnet, daß** die Drehzahl mindestens eines der Ventilatoren (17, 24) regelbar ist.

## Claims

1. Air conditioning device for electronic components with a partition (12) that is equipped with heat exchange elements (12, 13) on both sides and borders a first channel (8) with an intake (15) and an exhaust (16) for a flowing first fluid, whereby in a first operation mode of the device a second fluid, at the side of the partition (12) facing away from the first channel (8), is in a heat exchange with the first fluid and the electric components,
**characterized in that**
the air conditioning device (4) features three channels (6, 7, 8), whereby the partition (12) separates an exterior channel (8) from a middle channel (7),
that a Peltier element (9) that is equipped on both sides with heat exchange elements (10, 11) separates the middle channel (7) from an interior channel (6), and
that switchable flaps (18, 19, 20, 21) are provided at the ends of the channels (6, 7, 8) that guide the first fluid in a selectable manner in the first operating mode through the exterior channel (8) and in a second operating mode through the middle channel (7) and the second fluid (25) in a selectable manner in the first operating mode through the middle channel (7) and in the second operating mode through the interior channel (6).

2. Air conditioning device according to claim 1, **characterized in that** the first fluid is external air and the second internal air from an interior space (2) of a switch box (1) in which the electric components (3) are disposed.

3. Air conditioning device according to claim 2, **characterized in that** respectively a ventilator (17, 24) is provided for the internal air and the external air.

4. Air conditioning device according to one of the claims 1 to 3, **characterized in that** the Peltier element (9) is switched, in a third operation mode, as a heating element for the heating of the second fluid.

5. Air conditioning device according to one of the claims 1 to 4, **characterized in that** it is installed on an outer wall (5) or a door of a switch box (1), whereby its outer wall (5) delimits the interior channel (6)

6. Air conditioning device according to one of the claims 1 to 4, **characterized in that** it is implemented as a slide-in for a switch box (1) that features, for external air, an intake and an exhaust opening that are aligned with the intake (15) and the exhaust (16) for the first fluid.

7. Air conditioning device according to one of the claims 1 to 6, **characterized in that** the Peltier element (9) is deactivated in a first operation mode and is adjustable in a second operating mode in regard to its electrical energy intake.

8. Air conditioning device according to one of the claims 3 to 7, **characterized in that** the number of revolutions of at least one of the ventilators (17, 24) is adjustable.

## Revendications

1. Dispositif de climatisation pour des composants électroniques, doté d'une paroi de séparation (12) qui est pourvue des deux côtés d'éléments échangeurs de chaleur (12, 13) et qui délimite un premier canal (8) doté d'une entrée (15) et d'une sortie (16) pour un premier fluide s'écoulant, dans lequel un deuxième fluide est en échange thermique avec le premier fluide et les composants électroniques (3) dans un premier mode de fonctionnement du dispositif, selon le côté de la paroi de séparation (12) opposé au premier canal (8),
**caractérisé en ce**
**que** le dispositif de climatisation (4) présente trois canaux (6, 7, 8), la paroi de séparation (12) séparant un canal extérieur (8) d'un canal médian (7),
**qu'**un élément Peltier (9), pourvu des deux côtés d'éléments échangeurs thermiques (10, 11), sépare le canal médian (7) d'un canal intérieur (6), et
**que** des clapets (18, 19, 20, 21) réversibles sont prévus au niveau des extrémités des canaux (6, 7, 8), lesquels conduisent le premier fluide au choix par le canal extérieur (8) dans le premier mode de fonctionnement et par le canal médian (7) dans un deuxième mode de fonctionnement, conduisent le deuxième fluide (25) au choix par le canal médian (7) dans le premier mode de fonctionnement et par le canal intérieur (6) dans le deuxième mode de fonctionnement.

2. Dispositif de climatisation selon la revendication 1, **caractérisé en ce que** le premier fluide est de l'air extérieur et le deuxième fluide est de l'air intérieur en provenance d'un espace intérieur (2) d'une armoire électrique (1) dans laquelle les composants électroniques (3) sont disposés.

3. Dispositif de climatisation selon la revendication 2, **caractérisé en ce qu'**un ventilateur respectif (17, 24) est prévu pour l'air intérieur et pour l'air extérieur.

4. Dispositif de climatisation selon l'une quelconque des revendications 1 à 3, **caractérisé en ce que** l'élément Peltier (9) est commuté dans le troisième mode de fonctionnement en tant qu'élément de chauffage pour chauffer le deuxième fluide.

5. Dispositif de climatisation selon l'une quelconque des revendications 1 à 4, **caractérisé en ce qu'**il est disposé au niveau d'une paroi extérieure (5) ou d'une porte d'une armoire électrique (1), sachant que sa paroi extérieure (5) délimite le canal intérieur (6).

6. Dispositif de climatisation selon l'une quelconque des revendications 1 à 4, caractérisé en qu'il est réalisé comme un insert dans une armoire électrique (1), qui présente un orifice d'entrée et un orifice de sortie pour l'air extérieur, lesquels orifices sont alignés avec l'entrée (15) et la sortie (16) pour le premier fluide.

7. Dispositif de climatisation selon l'une quelconque des revendications 1 à 6, **caractérisé en ce que** l'élément Peltier (9) est désactivé dans le premier mode de fonctionnement et **en ce qu'**il peut être réglé dans le deuxième mode de fonctionnement pour absorber son énergie électrique.

8. Dispositif de climatisation selon l'une quelconque des revendications 3 à 7, **caractérisé en ce que** la vitesse de rotation d'au moins un des ventilateurs (17, 24) est réglable.
